# EUROPÄISCHE PATENTANMELDUNG

(11) **EP 1 708 264 A2**
(43) Veröffentlichungstag der Anmeldung: **04.10.2006**
(21) Anmeldenummer: 06101076.5
(22) Anmeldetag: 31.01.2006
(51) Int. Cl.: H01L 23/473

(54) **Kühlanordnung für ein elektrisches Steuergerät**

(30) Priorität: 31.03.2005 DE 102005015718
(71) Anmelder: ROBERT BOSCH GMBH, 70442 Stuttgart (DE)
(72) Erfinder: Lischeck, Andre, 71665, Vaihingen (DE); Schulz, Udo, 71665, Vaihingen/Enz (DE)

(57) **Zusammenfassung**

Es wird eine Kühlanordnung für ein elektrisches Steuergerät (13) vorgeschlagen, mit einem ersten Kühlmittelkreislauf (22) und einem zweiten Kühlmittelkreis (40), der vom ersten Kühlmittelkreislauf (22) mit Kühlmittel (52) ver- und entsorgbar ist, mit einem Kühlmittel (52) führenden Wärmetauscher (73), der am Steuergerät (13) angeordnet ist und der Teil des zweiten Kühhnittelkreislaufs (40) ist, wobei der erste Kühlmittelkreislauf (22) ein Teil des Kühlmittelkreislaufs einer Brennkraftmaschine (16) ist und wobei der zweite Kühlmittelkreislauf (40) durch ein Wechselventil (31) zuschaltbar ist.

## Beschreibung

### Stand der Technik

Die Erfindung betrifft eine Kühlanordnung für ein elektrisches Steuergerät nach der Gattung des unabhängigen Patentanspruchs. Bekannte Kühlanordnungen für elektrische Steuergeräte nutzen zur Kühlung des Steuergeräts Flüssigkeitskühlkreisläufe, deren Kühlmittel aus dem Kraftstoff der durch das Steuergerät gesteuerten Brennkraftmaschine besteht. Hierzu wird die Kraftstoffleitung zwischen Kraftstofftank und Brennkraftmaschine als Kühlmitteldurchlauf genutzt. Die Kraftstoffleitung wird dazu am Gehäuse des Steuergeräts Wärme übertragend bzw. aufnehmend angelegt oder durchgeführt. Derartige Anordnungen sind bereits von Fahrzeugen mit Dieselmotoren bekannt, bei denen der Wärmeübergang vom Steuergerät auf den Dieselkraftstoff von nicht allzu großer Bedeutung ist. Bei Ottomotoren besteht diese Möglichkeit jedoch nicht, da durch die Verlustleistung des zu kühlenden Steuergeräts der Kraftstoff unzulässig stark erwärmt werden könnte. Daher wird bei Ottomotoren der Kühlwasserkreislauf zur Kühlung des Steuergeräts genutzt. Nachteilig an dieser Lösung ist, dass durch die Kühlflüssigkeit das Steuergerät stets einem großen Temperaturhub ausgesetzt wird. Das kann zu erhöhten Aufwendungen im Steuergerät zur Erfüllung der Temperaturwechselfestigkeit führen.

### Vorteile der Erfindung

Die erfindungsgemäße Kühlanordnung für ein elektrisches Steuergerät mit den Merkmalen des Hauptanspruchs hat die Vorteile, dass eine einfache Vorschaltanordnung bereitgestellt wird, durch die der Kühlmittelstrom erst im Bedarfsfall für das Steuergerät freischaltbar ist und andererseits ein Überhitzen des gestauten Kühlwasserstroms unterbunden werden kann.

Durch die in den Unteransprüchen aufgeführten Maßnahmen sind vorteilhafte Weiterbildungen der Kühlanordnung nach dem Hauptanspruch möglich.

Führt man das Wechselventil als elektrisch betätigbares Ventil aus, das zudem temperaturabhängig schaltbar ist, so erhält man eine Kühlanordnung, deren Wechselventil einerseits sehr genau steuerbar ist und bei dem ggf. durch die Temperaturabhängigkeit der Ansteuerung des Ventils eben die Temperatur eines bestimmten Bauteils, bspw. des sich am stärksten bzw. schnellsten erwärmenden Bauteils, innerhalb des Steuergeräts für die Zuschaltung des Kühlmittelkreislaufs berücksichtigt werden kann.

Ist ein Temperaturfühler vorhanden, so kann dessen Zustand und somit die entsprechende Temperatur bspw. über einen Rechner ermittelt werden. Dies ermöglicht die Integration der Temperaturfühlung in die zentrale Rechnereinheit (CPU) des Steuergeräts. So wäre eine Verarbeitung des Temperatursignals in einer anderen externen Einheit nicht notwendig und würde somit zu einem kompakten, wenig störungsanfälligen Aufbau führen.

Nach einer weiteren Ausgestaltung der Erfindung ist vorgesehen, dass das Wechselventil ein selbstschaltendes Ventil ist. Dies hat den Vorteil, dass kein elektronisch auszuwertender Temperaturfühler vorhanden zu sein braucht, dessen Zustand auch nicht durch eine CPU oder einen anderen Rechner zu verarbeiten wäre. Es ergibt sich somit eine ganz besonders einfache Kühlanordnung.

Eine sehr einfache Ausführung für ein selbstschaltendes Wechselventil besteht darin, ein im Wechselventil vorhandenes, die Ventilfunktion verwirklichendes Leitelement durch ein bistabiles Federelement zu schalten. Als besonders geeignet hat sich hier in diesem Fall ein Thermobimetallschnappelement erwiesen, das ein spezielles Ausführungsbeispiel für ein bistabiles Federelement ist.

### Zeichnungen

In den Zeichnungen ist ein Ausführungsbeispiel einer erfindungsgemäßen Kühlanordnung dargestellt. Es zeigen:
- Figur 1: eine Kühlanordnung für ein elektrisches Steuergerät mit einem Wechselventil, wobei der Kühlmittelkreislauf des Steuergeräts an den Kühlmittelkreislauf einer Brennkraftmaschine angeschlossen ist,
- Figur 2: ein elektrisch betätigbares Wechselventil,
- Figur 3: ein Steuergerät mit einem Temperaturfühler und einem Rechner,
- Figur 4: ein Wechselventil in selbstschaltender Ausführung mit einem bistabilen Federelement.

### Beschreibung

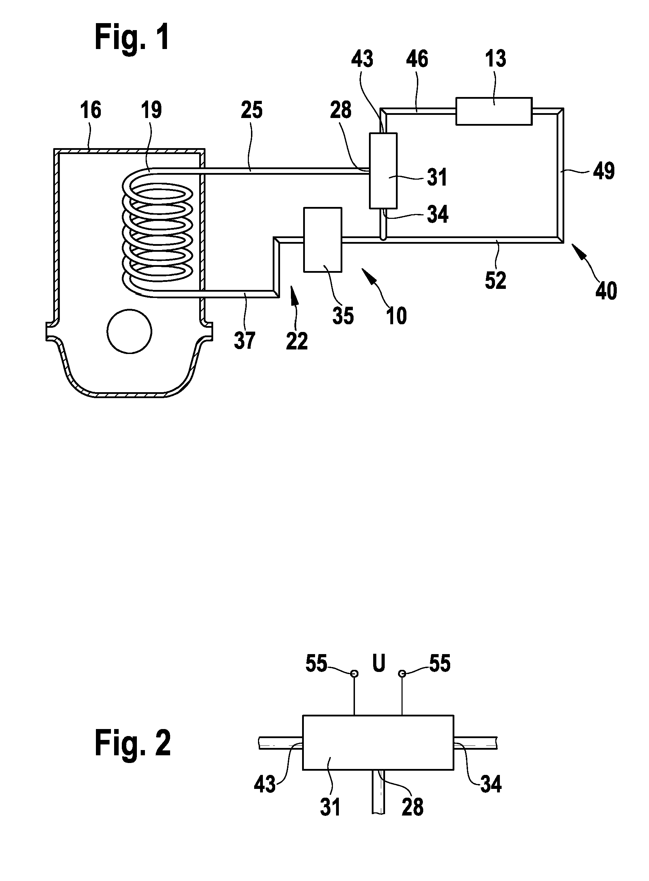

In Figur 1 ist eine Kühlanordnung 10 für ein elektrisches Steuergerät 13 dargestellt. Die Kühlanordnung 10 umfasst auch eine Brennkraftmaschine 16 und deren Wassermantel 19. Die Kühlanordnung 10 weist zunächst einen ersten Kühlmittelkreislauf auf, der hier mit 22 bezeichnet ist. Dieser erste Kühlmittelkreislauf befmdet sich zwischen dem Wassermantel 19, einem Rohrabschnitt 25 zwischen dem Wassermantel 19 und dem Einlass 28 eines Wechselventils 31, dem Wechselventil 31, einem Auslass 34 des Wechselventils und dem den Auslass 34 mit dem Wassermantel 19 über einen Kühler 35 verbindenden Rohrabschnitt 37. Ein zweiter Kühlmittelkreislauf 40 ist kein echter Kreislauf, da dieser lediglich eine Verlängerung bzw. einen parallel ab- und wieder zugeführten Zweig des ersten Kühlmittelkreislaufs 22 darstellt. Der zweite Kühlmittelkreislauf 40 beginnt bei einem ersten Auslass 43 des Wechselventils 31, führt über eine Rohrverbindung 46 zum Steuergerät 13, durchströmt dort einen in Figur 1 nicht dargestellten Wärmetauscher, verlässt das Steuergerät und geht über in eine weitere Rohrverbindung 49, die letztlich in den Rohrabschnitt 37 übergeht. Der zweite Kühlmittelkreislauf 40 ist durch das Wechselventil 31 je nach Anforderung an die Kühlung des Steuergeräts 13 zuschaltbar.

Figur 1 zeigt somit eine Kühlanordnung 10 für ein elektrisches Steuergerät 13, mit einem ersten Kühlmittelkreislauf 22 und einem zweiten Kühlmittelkreislauf 40, der vom ersten Kühlmittelkreislauf 22 mit Kühlmittel 52 ver- und entsorgbar ist. Am Steuergerät 13 ist ein Wärmetauscher angeordnet, der das Kühlmittel 52 führt und der Teil des zweiten Kühlmittelkreislaufs 40 ist. Der erste Kühlmittelkreislauf 22 ist ein Teil des Kühlmittelkreislaufs einer Brennkraftmaschine 16. Der zweite Kühlmittelkreislauf 40 ist durch ein Wechselventil 31 zuschaltbar.

In Figur 2 ist in schematischer Darstellung das Wechselventil 31 dargestellt. Das Wechselventil 31 verfügt über den bereits erwähnten Einlass 28, den Auslass 43 und den zweiten Auslass 34. Dieses Wechselventil 31 verfügt über elektrische Anschlüsse 55, durch die das Wechselventils 31 elektrisch betätigbar ist. Die elektrischen Anschlüsse 55 führen zu einem hier nicht dargestellten elektrischen Stellorgan, das im Wechselventil 31 für die entsprechende Umlenkung des eingelassenen Kühlmittels 52 sorgt. Die Stromversorgung der elektrischen Anschlüsse 55 ist bspw. temperaturabhängig, wodurch auch das Wechselventil 31 letztlich temperaturabhängig schaltbar ist.

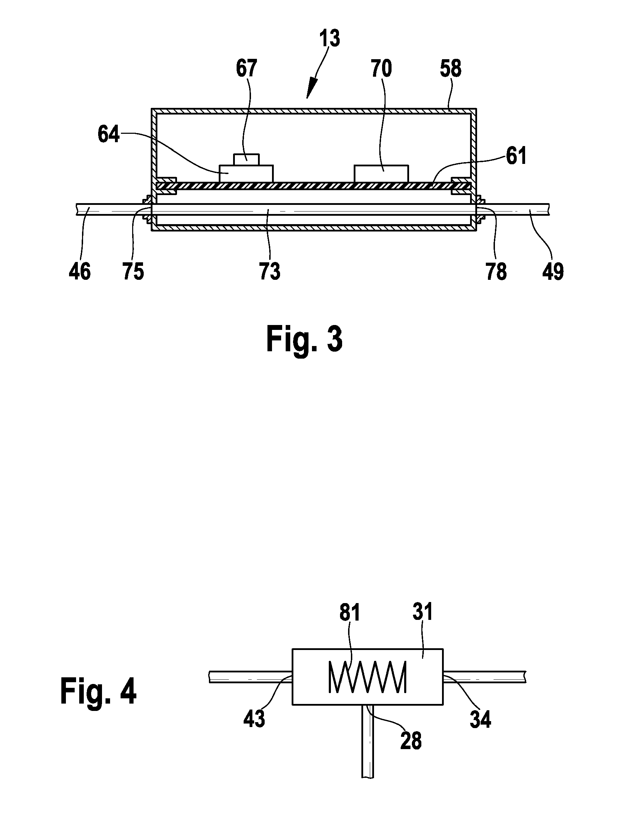

Figur 3 zeigt das Steuergerät 13 bzw. einen Längsschnitt durch dieses. Das Steuergerät 13 hat ein Gehäuse 58, das eine Leiterplatte 61 umgibt. Auf dieser Leitplatte sind im Beispiel ein temperaturempfmdlicher Prozessor 64 angeordnet, auf dem ein Temperaturfühler 67 angeordnet ist. Ein Rechner 70 auf der Leiterplatte 61 verarbeitet das Signal des Temperaturfühlers 67 und steuert über hier nicht dargestellte elektrische Verbindungen, welche mit den elektrischen Anschlüssen 55 des Wechselventils 31 verbunden sind, das Wechselventil 31 und dessen Schaltzustand. In Figur 3 befmdet sich unterhalb der Leiterplatte 61 ein Wärmetauscher 73, der sowohl einen Einlass 75 und einen Auslass 78 aufweist. Der Einlass 75 ist mit der Rohrverbindung 46 und der Auslass 78 mit der Rohrverbindung 49 verbunden. Figur 3 zeigt somit, dass die Kühlanordnung über einen Temperaturfühler 67 verfügt, dessen Zustand von einem Rechner 70 ermittelbar ist. Der Rechner 70 kann auch eine zentrale Prozessoreinheit 64 (CPU) des Steuergeräts 13 sein.

Der Wärmetauscher 73 könnte auch oberhalb der Leiterplatte 61 angeordnet sein, beispielsweise auch in das Gehäuse 78 integriert sein.

In Figur 4 ist das Wechselventil 31 als selbstschaltendes Ventil dargestellt. Das Wechselventil 31 weist ein bistabiles Federelement 81 auf, welches das Ventil 31 schaltet. Es ist vorgesehen, dass das Federelement ein Thermobimetallschnappelement ist, das thermisch aktivierbar ist. Letzteres bedeutet, dass das bistabile Federelement 81 durch die Temperatur des Kühlmittels 52, welches bspw. zwischen dem Einlass 28 und dem Auslass 34 strömt, ein Schaltvorgang des bistabilen Federelements ausgelöst wird, wodurch die Strömungsänderung vom Einlass 28 zum Auslass 43 erfolgt.

Vorteil der Erfindung ist, dass das Steuergerät 13 nur dann vom Kühlwasserstrom durchflossen wird, wenn eine bestimmte Temperatur im Steuergerät 13 erreicht wird. Dadurch werden die auf das Steuergerät 13 wirkenden Temperaturhübe minimiert. Bei einer Anordnung ohne ein Wechselventil 31 würde z.B. im Teillastbereich und/oder bei geringen Außentemperaturen, d.h. wenn das Steuergerät 13 wenig Verlustwärme produziert und keine Flüssigkeitskühlung notwendig wäre, das Steuergerät 13 durch die Kühlflüssigkeit 52 zusätzlich erwärmt. Die Bypassstrecke zwischen dem Auslass 34 und dem Zusammenfluss beider Kühlmittelkreisläufe 40 und 22 bewirkt, dass vor dem Wärmetauscher 73 des Steuergeräts 13 keine Stauwärme entsteht und keine großen Druckschwankungen im Kühlkreislauf 40 auftreten. Wird das Wechselventil 31 elektrisch betätigt, kann mittels des Temperaturfühlers 67 die Temperatur des Steuergeräts 13 gemessen und von der CPU 64 oder dem Rechner 70 erfasst werden. Wird ein Schwellenwert überschritten, so wird dann das Wechselventil 31 elektrisch betätigt. Dies hat den Vorteil, dass der Aufbau für verschiedene Steuergeräteapplikationen unverändert bleiben kann und die Anpassung an unterschiedliche Einbausituationen und/oder unterschiedliche Steuergerätverlustleistung allein durch die Software erfolgen kann, welche ursächlich für die Entscheidung ist, ob das Wechselventil 31 betätigt werden soll oder nicht.

Wird ein selbstschaltendes Wechselventil 31 mit einem Thermobimetallschnappelement 81 verwendet, so hat dies den Vorteil gegenüber konventionellen Bimetallstellern, dass es einen großen Öffnungshub (Schnapphub) beim Erreichen einer so genannten Schnapptemperatur macht. Dadurch ist gewährleistet, dass das Steuergerät 13 bei Erreichen einer Grenztemperatur nicht überhitzt. Dieses Stellelement und damit das Wechselventil 31 ist unmittelbar am Steuergerätegehäuse 58 anzuordnen, damit es die Temperaturerhöhung des Steuergeräts 13 erfährt.

## Patentansprüche

1. Kühlanordnung für ein elektrisches Steuergerät (13), mit einem ersten Kühlmittelkreislauf (22) und einem zweiten Kühlmittelkreislauf (40), der vom ersten Kühlmittelkreislauf (22) mit Kühlmittel (52) ver- und entsorgbar ist, mit einem Kühlmittel (52) führenden Wärmetauscher (73), der am Steuergerät (13) angeordnet ist und der Teil des zweiten Kühlmittelkreislaufs (40) ist, wobei der erste Kühlmittelkreislauf (22) ein Teil des Kühlmittelkreislaufs einer Brennkraftmaschine (16) ist und wobei der zweite Kühlmittelkreislauf (40) durch ein Wechselventil (31) zuschaltbar ist.

2. Kühlanordnung nach Anspruch 1, **dadurch gekennzeichnet, dass** das Wechselventil (31) elektrisch betätigbar.

3. Kühlanordnung nach Anspruch 2, **dadurch gekennzeichnet, dass** das Wechselventil (31) temperaturabhängig schaltbar ist.

4. Kühlanordnung nach Anspruch 2 oder 3, **dadurch gekennzeichnet, dass** ein Temperaturfühler (67) vorhanden ist, dessen Zustand von einem Rechner (70) ermittelbar ist.

5. Kühlanordnung nach Anspruch 4, **dadurch gekennzeichnet, dass** das der Rechner (70) eine CPU (64) des Steuergeräts (13) ist.

6. Kühlanordnung nach Anspruch 1, **dadurch gekennzeichnet, dass** das Wechselventil (31) ein selbstschaltendes Ventil ist.

7. Kühlanordnung nach Anspruch 6, **dadurch gekennzeichnet, dass** ein bistabiles Federelement das Ventil (31) schaltet.

8. Kühlanordnung nach Anspruch 7, **dadurch gekennzeichnet, dass** das Federelement (81) ein Thermobimetallschnappelement ist.
